# EUROPEAN PATENT SPECIFICATION

(11) **EP 0 763 890 B1**
(45) Date of publication and mention of the grant of the patent: **08.08.2001**
(21) Application number: 96114839.2
(22) Date of filing: 16.09.1996
(51) Int. Cl.: H03H 11/04, H03H 17/02

(54) **Matched filter**
Signalangepasstes Filter
Filtre apparié

(30) Priority: 18.09.1995 JP 26357395
(43) Date of publication of application: 19.03.1997
(73) Proprietor: YOZAN INC., Tokyo 155 (JP); SHARP KABUSHIKI KAISHA, Osaka-shi, Osaka-fu 545-0013 (JP)
(72) Inventor: Shou, Guoliang c/o Yozan. Inc, Tokyo 155, (JP); Zhou, Changming c/o Yozan. Inc, Tokyo 155, (JP); Yamamoto, Makoto c/o Yozan. Inc, Tokyo 155, (JP); Takatori, Sunao c/o Yozan. Inc, Tokyo 155, (JP)
(74) Representative: Grünecker, Kinkeldey, Stockmair & Schwanhäusser Anwaltssozietät

(56) References cited:
- US-A- 4 507 746
- US-A- 5 408 192
- ELECTRONICS AND COMMUNICATION ENGINEERING JOURNAL, vol. 5, no. 2, 1 April 1993, pages 59-64, XP000363818 POVEY G J R ET AL: "SIMPLIFIED MATCHED FILTER RECEIVER DESIGNS FOR SPREAD SPECTRUM COMMUNICATIONS APPLICATIONS"

## Description

### FIELD OF THE INVENTION

The present invention relates to a matched filter effective for a spread spectrum communication system for such as mobile cellular radio and wireless LAN, especially to a matched filter including i) a main sampling and holding circuit with a plurality of sampling and holding circuits parallelly connected to an input voltage for holding the input voltage in time scries, each the sampling and holding circuit having first and second outputs corresponding to first and second values of PN code, ii) the first adder for adding the first outputs of the sampling and holding circuits, iii) the second adder for adding the second outputs of the sampling and holding circuits, iv) a subtraction circuit for subtracting an output of the second adder from an output of the first adder;

### BACKGROUND OF THE INVENTION

US-A-4,507746 proposes a matched filter for secure communication systems comprising a signal shift register that receives the input signals and a reference shift register, containing a maximal-length sequence code. Exclusive-OR gates couple the coded signal to summing networks for adding the appropriate signals entering the unit to produce a matched filter output.

The applicants have proposed a matched filter in Japanese patent application number 7-212438. Paying attention that PN (Pseudo-Noise) code is a I bit code, a circuit for multiplication is simplified by a multiplexer.

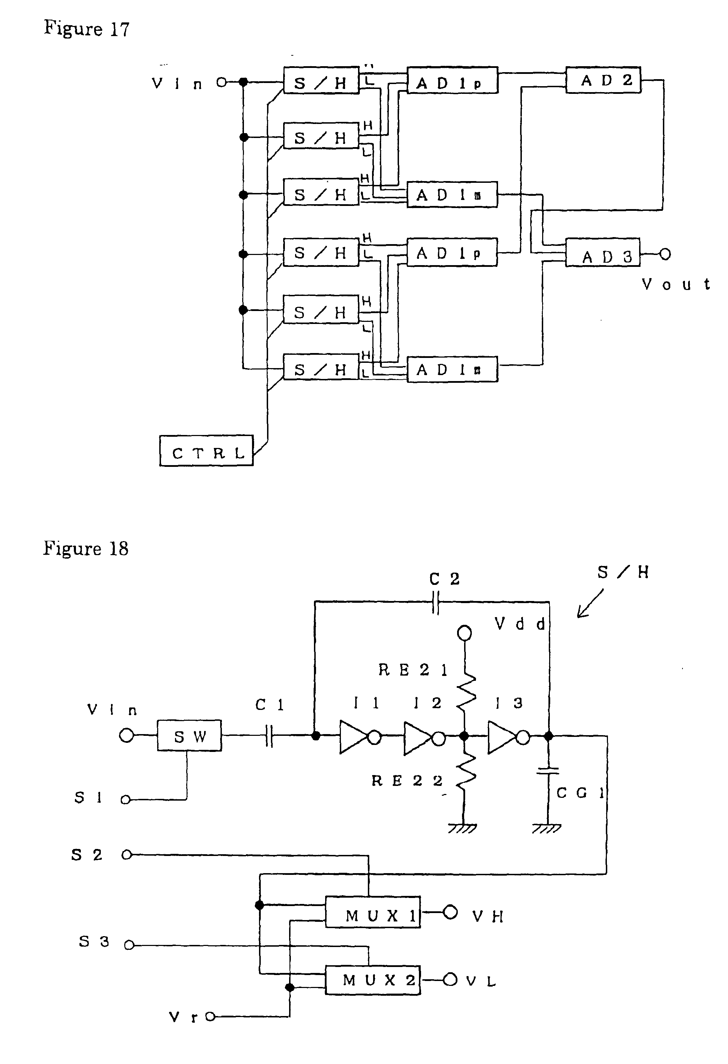

Fig. 17 shows the matched filter circuit proposed and Fig. 18 shows a sampling and holding circuit S/H in the matched filter circuit of Fig. 17. In the sampling and holding circuit S/H, an analog input voltage Vin is held in a capacitance C1 and is input to an output terminal VH or VL according whether the PN code is plus or minus. The outputs are added in adders AD1p and AD1m, and then, minus elements are subtracted from plus elements by two steps of inverse addition by AD2 and AD3.

In such an analog calculating circuit, an offset voltage is generated by residual charge in an inverter and a capacitance, and consequently, the accuracy of an output becomes worse. In order to reduce the electrical charge, it is necessary to short-circuit to the part of the capacity, for refreshing. As it is necessary to stop the calculation when the circuit is refreshed, the speed of a calculation in whole of the circuit must be sacrificed.

### SUMMARY OF THE INVENTION

The present invention solves the above conventional problems and has an object to provide a matched filter in which the total circuit can be refreshed without decreasing the calculation speed.

In a matched filter according to the present invention, it is additionally settled that
i) a plurality of auxiliary sampling and holding circuits for holding a part of analog input voltage to be held in the main sampling and holding circuit,
ii) the second addition and subtraction circuit including a circuit equivalent to addition and subtraction circuit,
iii) a multiplexer for alternatively outputting an output of addition and subtraction circuit or the second addition and subtraction circuit.
Consequently, a period is settled for stopping a sampling and holding circuit and addition and subtraction circuit in the main sampling and holding circuit; a refresh is performed in the period.

It is possible to obtain higher accuracy of calculation keeping the high speed of calculation by the matched filter according to the present invention.

### BRIEF DESCRIPTION OF THE DRAWINGS

Fig. 1 shows a block diagram of a matched filter of the first embodiment according to the present invention.

Fig. 2 shows a block diagram of a sampling and holding circuit of the embodiment in Fig. 1.

Fig. 3 shows a block diagram of the main sampling and holding circuit of the embodiment in Fig. 1.

Fig. 4 shows a unit sampling and holding circuit of the main sampling and holding circuit in Fig. 3.

Fig. 5 shows an auxiliary sampling and holding circuit in the embodiment.

Fig. 6 shows a circuit of a switch.

Fig. 7 shows a circuit of another switch.

Fig. 8 shows a circuit of a multiplexer.

Fig. 9 shows a block diagram of an addition and subtraction means.

Fig. 10 shows a circuit of an addition portion.

Fig. 11 shows a circuit of another addition circuit.

Fig. 12 shows a circuit of a subtraction circuit.

Fig. 13 shows a timing chart of the actions in the embodiment.

Fig. 14 shows a circuit for generating PN codes.

Fig. 15 shows a circuit for generating a sampling and holding signal in the main sampling and holding circuit.

Fig. 16 shows a circuit for generating a sampling and holding signal in an auxiliary sampling and holding circuit.

Fig. 17 shows a block diagram of a conventional matched filter.

Fig. 18 shows a sampling and holding circuit of a conventional matched filter.

### PREFERRED EMBODIMENT OF THE PRESENT INVENTION

Hereinafter the first embodiment of a matched filter according to the present invention is described with reference to the attached drawings.

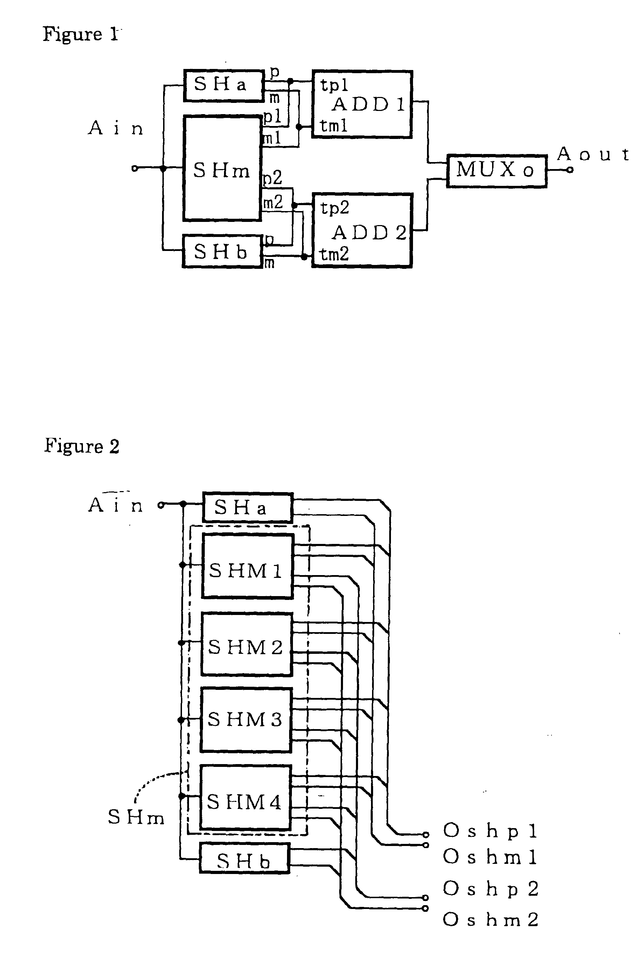

In Fig. 1, a matched filter includes auxiliary sampling and holding circuits SHa and SHb in addition to a main sampling and holding circuit SHm which is similar to a conventional sampling and holding circuit (with a plurality of S/Hs in Fig. 17). The auxiliary sampling and holding circuits have the function to hold one of data to be held in the main sampling and holding circuit. That is, the auxiliary sampling and holding circuit can be used instead of one of sampling and holding circuits in the main sampling and holding circuit. Therefore, it is possible to sequentially stop sampling and holding circuits one after another in the main sampling and holding circuit. As two of auxiliary sampling and holding circuits are settled as SHa and SHb, one of the two can be stopped.

Outputs of sampling and holding circuits SHm and SHa are input to the first addition and subtraction circuit ADD1, and those of SHm and SHb are input to the second addition and subtraction circuit ADD2. These addition and subtraction circuits perform addition and subtraction similarly to the conventional addition and subtraction circuit. In Fig. 1, outputs of plus and minus of SHa and SHb are shown by p and m, and outputs of plus and minus of SHm for inputting ADD1 are shown by p1 and m1, for inputting ADD2 are shown by p2 and m2. One of the two addition and subtraction circuits can be stopped when two of addition and subtraction circuits are settled. Then outputs of addition and subtraction circuits ADD1 and ADD2 are alternatively output from a multiplexer MUXo as an analog output voltage Aout.

Fig. 2 shows the main sampling and holding circuit SHm in detail, in which auxiliary sampling and holding circuits are also shown. The main sampling and holding circuit SHm includes four sampling and holding circuit modules SHM1, SHM2, SHM3 and SHM4. These sampling and holding circuits generate two kinds of outputs of p and m according to the PN code to be multiplied to the held data. These outputs are input to ADD1 and ADD2, respectively, by integrating outputs of SHa and SHm, and also SHb and SHm. Here it is defined that a plus clement and a minus element to be input to ADD1 are Oshp1, Oshm1, respectively, and those to be input to ADD2 arc Oshp2 and Oshm2, respectively. An input terminal of a plus element and d minus element of ADD1 are tp1 and tm1, respectively, and those of ADD2 are tp 2 and tm2, respectively.

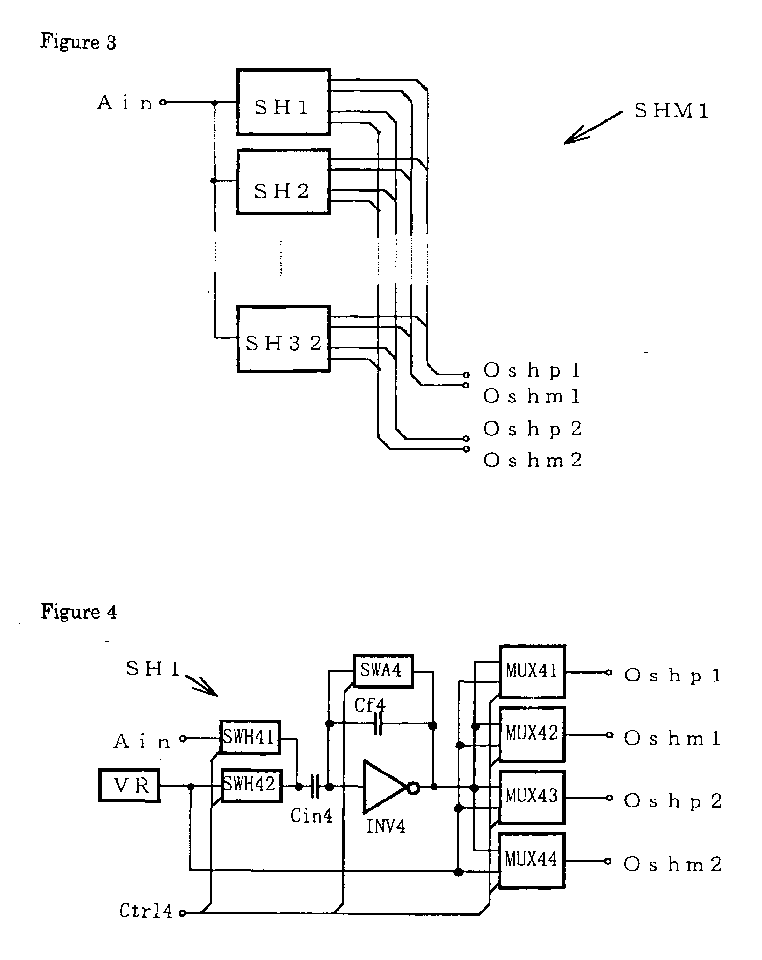

As in Fig. 3, a sampling and holding circuit module holding circuits SH1 to SH32, consequently, it is possible to hold a 128 data as a whole of SHm (32 × 4=128). As SHM2 to SHM4 are structured the same as that of SHM1, the description of them is omitted.

As in Fig. 4, an unit sampling and holding circuit SH1 includes an input switch SWH41 connected to the input voltage Ain and an input capacitance Cin4 connected to the input switch. The input capacitance is input to an inverter INV4 including three stages of serial MOS inverters. An output of the INV4 is fed back to its input through feedback capacitance Cf4. The linearity of the relationship between an input and an output is surely kept by a high open loop gain of INV4. INV4 is similar to the circuit of the applicants' application of Japanese open-laid publication number 7-94957, which obtains high gain by three stages of MOS inverters, as well as prevents unnecessary oscillation by a grounded capacitance and a balancing resistance. When data is held by a sampling and holding circuit, opening SWH41 after closing , holding an electric charge in capacitances Cin4 and Cf4, and an input voltage Ain is output from the output of INV4. The ratio of the capacity of capacitances Cin4 and Cf4 is 1:1,and an inverse of Ain is output from INV4 as it is. To the output of INV4, multiplexers MUX41, MUX42, MUX43 and MUX44 are connected, which are corresponding to Oshp1, Oshm1, Oshp2 and Oshm2. Only one of multiplexers outputs Ain and others output the reference voltage. The reference voltage is the reference of the output voltage, which corresponds to 0.

The unit sampling and holding circuit SH1 includes switches for refreshing SWH42 and SWA4, which are controlled by a control signal Ctrl4. Multiplexers MUX41 to MUX44 are also controlled by the Ctrl4. SWH42 is for connecting VR to Cin4 and SWA4 is for short-circuiting the input and output of INV4. SH1 is refreshed and the offset is canceled by closing the switches. As SH1 cannot hold and output Ain during refreshing, SHa or SHb is used in place of it. When refreshing is performed, MUX41 to MUX44 are settled to output the reference voltage and output the reference voltage to addition and subtraction circuit.

As SH2 to SH32 are structured same as that of SH1, the description is omitted.

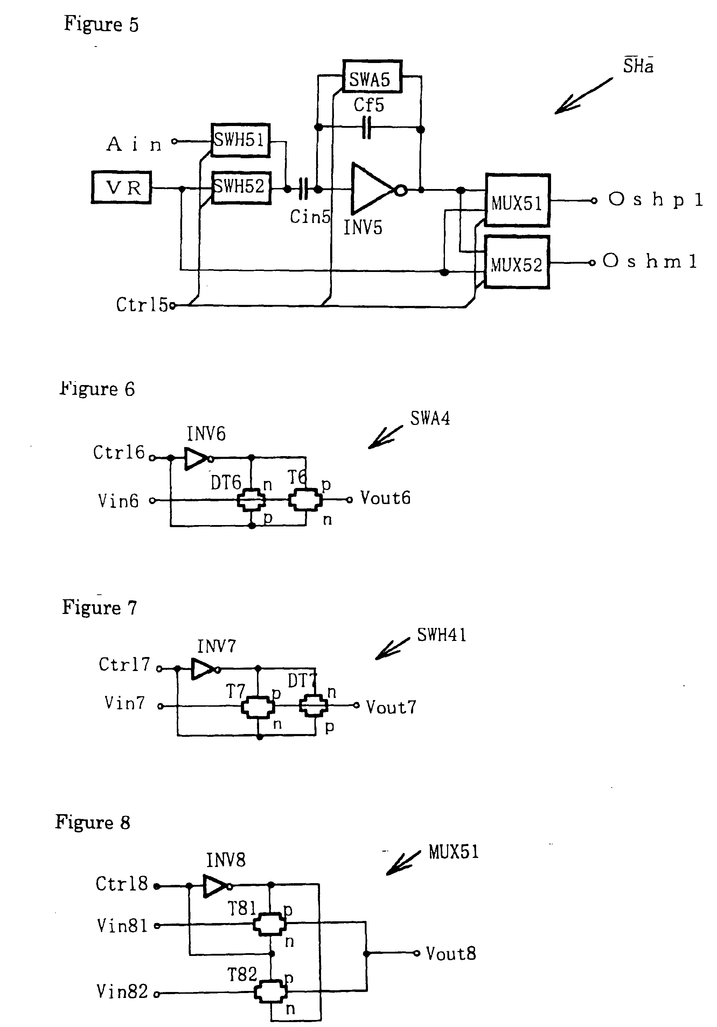

As in Figure 5, auxiliary sampling and holding circuit SHa is a circuit similar to the unit sampling and holding circuit. The different point is that the number of multiplexers of auxiliary sampling and holding circuit is two, not four. The SHa outputs only Oshp1 and Oshm1 which are outputs to ADD1. In the Fig. 5, SWH51 is a switch for connecting the Ain to an input capacitance Cin5, SWH52 is a switch for connecting the VR to a Cin5, INV5 is a three stages of MOS inverter circuit connected to Cin5, Cf5 is a switch for shortening circuit an input and output of INV5, MUX51 is a multiplexer for outputting an output of INV5 as Oshp1, and MUX52 is a multiplexer for outputting an output of INV5 as Oshm1. The ratio of capacities of the capacitances of the Cin5 and Cf5 is 1:1. The inverse of Ain is output from INV5 as it is.

Switches SWH51, SWH52, SWA5, MUX51 and MUX52 are controlled by a control signal Ctrl5. When the refresh is performed, SWH51 is opened, SWH52 is closed, SWA5 is closed, and MUX51 and MUX52 arc settled for outputting the reference voltage. An offset voltage is reduced by it and an output to an addition and subtraction circuit is the reference voltage. The auxiliary sampling and holding circuit SHb generates outputs Oshp2 and Oshm2 for ADD2 by a similar structure.

In Fig. 6. the switch SWA4 (in Fig. 4) switches a transistor circuit T6 which consists of pMOS and nMOS drain and source of which are connected to each other. The source of pMOS and drain of nMOS are connected to each other, by a control signal Ctrl6. An input voltage Vin6 is connected to the drain of pMOS of Tr6 through a dummy transistor DT6. Ctrl6 is input to gates of nMOS of T6 and nMOS of DT6, as well as to gates of pMOS of T6 and nMOS of DT6 through an inverter INV6. T6 is closed when Ctrl6 is high level. DT6 consists of MOSs parallelly connected with inverse polarity of those of T6. It cancels offset of Cin4 and output of Vout6 is more accurate. As SWA5 is the same as SWA4, the description of it is omitted.

In Fig. 7, a switch SWH41 (shown in Figure 4) is structured by inverting the arrangement of the transistor and dummy transistor in SWA4, and can cancel the an offset of output. T7 is a MOS switch in which nMOS and pMOS are connected in parallel to the input voltage Vin, DT7 is a dummy transistor for outputting an inverse polarity of MOS of T7 to an output of T7, INV7 is an inverter for inputting a control signal Ctrl7 to a pMOS of T7 and nMOS of DT7. As switches SWH42, SWH51 and SWH52 are the same as the switch SWH41, the description of them is omitted.

In Fig. 8, a multiplexer MUX51 (shown in Fig. 5) switches two of parallel MOS switches by a control signal with inverse polarity of control signal. MOS switches T81 and T82 are settled, in which pMOS and nMOS are settled in parallel to input voltages Vin81 and Vin 82. A control signal Ctrl8 is input to a gate of nMOS of T81 and a gate of pMOS of T82, and also input to a gate of pMOS of T81 and a gate of nMOS of T82 through an inverter INV8. When Ctrl8 is high level, T81 is closed, and when it is low level, T82 is closed. A Vin81 or Vin82 is output as an output Vout. As multiplexers MUXo, MUX41, MUX42, MUX43, MUX44 and MUX52 are the same as MUX51, the description of them is omitted.

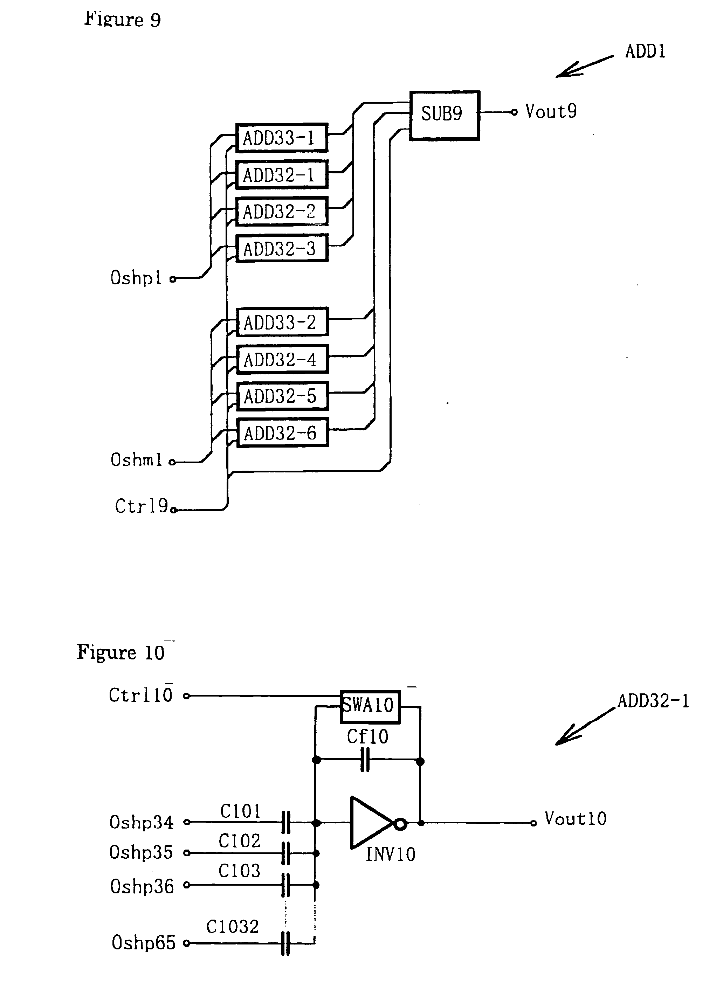

In Fig. 9, the addition and subtraction means ADD1 (shown in Fig. 1) includes four addition portion ADD33-1, ADD32-1, ADD32-2 and ADD32-3 for adding Oshp1, and also includes four addition portions ADD33-2, ADD32-4, ADD32-5 and ADD32-6 for adding Oshm1. Addition portions ADD33-1 and ADD33-2 are the addition portion for 33 inputs, and add plus and minus outputs of SHM1 and SHa. ADD32-1, ADD32-2 and ADD32-3 are addition portions of 32 inputs, which add plus outputs of SHM2, SHM3 and SHM4. ADD32-4, ADD32-5 and ADD32-6 are addition portions of 32 inputs, which add minus outputs of SHM2, SHM3 and SHM4. Addition results of Oshp1 and Oshm1 are input to SUB9, and the addition result of Oshm1 is subtracted from that of Oshp1. The stop and refreshment of addition and subtraction means ADD1 is controlled by a control signal Ctrl9 in order that the multiplexers MUX41 and MUX42 (shown in Fig. 4) in the sampling and holding circuit SHm, and the MUX51 and MUX52 (shown in Figure 5) in the SHa, corresponding to MUX41 and MUX42, respectively, output the reference voltage. Therefore, all the outputs of addition circuits, that is all the inputs of subtraction circuits, are the reference voltage, then the addition and subtraction circuit ADD1 outputs the reference voltage as Vout9. As ADD2 is the same as ADD1, the description is omitted.

In Figure 10, ADD32-1 includes a capacitive coupling in which 32 capacitances from C101 to C1032 are connected parallelly to inverter circuit INV10. These capacitances have the same capacity as ADD32-1. The inverter circuit INV10 consists of three stages of MOS inverters. An output of INV10 is fed back to its input by a feedback capacitance Cf10, and is output as an output Vout10 which is an inverted output of the capacitive coupling with good linearity. The capacitance ratio of capacitances C101 to C1032 and Cf10 is 1:32. For example when an input voltage is equally impressed to C101 to C1032, the INV10 outputs a voltage equal to the input voltage. Also a switch SWA10 (the structure is the same as SWA4) for short-circuiting an input and output is connected to INV10, and refreshes ADD32-1 when the INV10 is closed by a control signal Ctrl10. As ADD32-2 to ADD32-6 are the same as ADD32-1, the description is omitted.

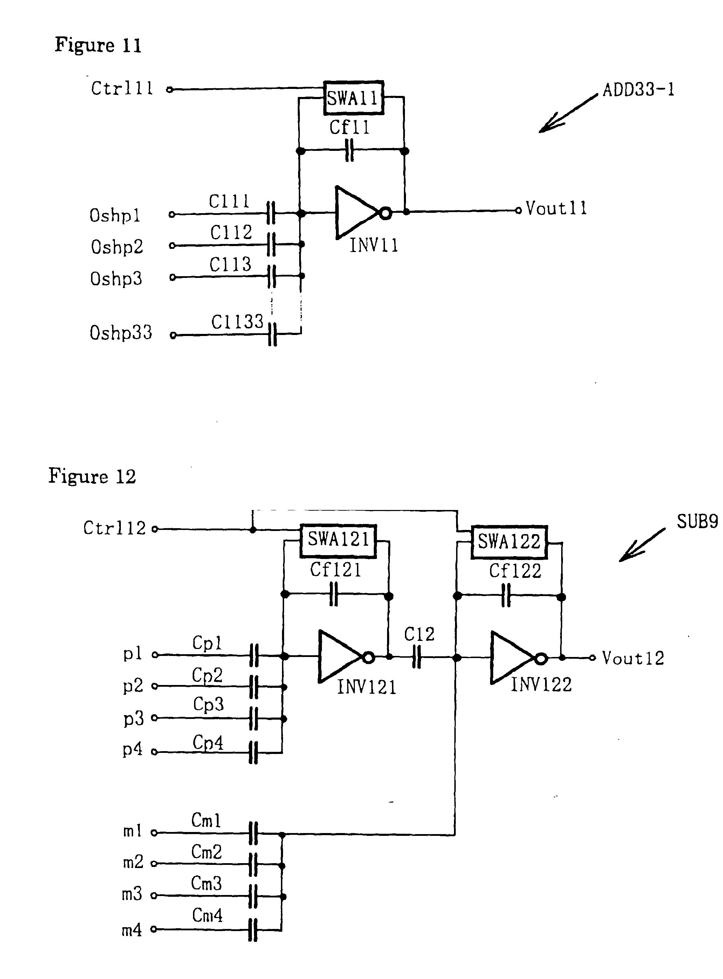

In Figure 11, ADD33-1 includes a capacitive coupling in which 33 capacitances from C111 to C1133 are connected in parallel with the same capacity as ADD33-1. An output of the capacitive coupling is connected to an inverter circuit INV11 consists of three stages of MOS inverters. An output of INV11 is fed back to its input by a feedback capacitance Cf11, and is output as an output Voutll which is an inverted output of the capacitive coupling with good linearity. The capacitance ratio of capacitances C111 to C1133 and Cf11 is 1:32. The same weight of ADD32-1 is weighted. As an invalid input (the reference voltage) is input to which one of C111 and C1133, the ratio is settled with ignoring one of input capacitances.

For example, when an input voltage is equally impressed to C111 to C1133, the INV11 outputs an inverted output of the input voltage. Also a switch SWA11 (the structure is the same as SWA4) for short-circuiting an input and output is connected to INV11, and refreshes ADD33-1 when the INV11 is closed by a control signal Ctrl11. As mentioned, all the inputs of addition portions are the reference voltage when a refreshing is performed, therefore, an output Vout11 is the reference voltage by short-circuiting an input and output of the inverter INV11. As ADD32-2 is the same as ADD32-1, the description is omitted.

In Figure 12, the subtracter SUB9 includes a capacitive coupling in which four capacitances Cp1, Cp2, Cp3, Cp4 for adding outputs of ADD33-1, ADD32-1, ADD32-2 and ADD32-3 (shown by p1, p2, p3 and p4 in the figure). An output of the capacitive coupling is connected to an inverter circuit INV121 consisting of three stages of MOS inverters. An output of INV121 is fed back to its input by a feedback capacitance Cf121, for good linearity. An inverter circuit INV122 similar to INV121 is connected to the following stage to the INV122 through a capacitance C12. A capacitive coupling consisting of capacitances Cm1, Cm2, Cm3 and Cm4 is connected to INV122. A feedback capacitance Cf122 is also connected to INV122. Minus outputs of ADD33-2, ADD32-4, ADD32-5 and ADD32-6 are input to the capacitances, and the addition result of them are output. An output of INV121 is the inverse of addition result of p1 to p4. INV121 is added to the summation of m1 to m4 in C12 and the capacitive coupling including Cm1 to Cm4. As the addition result is inverted by INV122, the value subtracted the addition result of m1 to m4 from the addition result of p1 to p4 is generated as Vout12 of the output of INV122. The ratio of the capacities of each capacitance of Cp1 to Cp4 and of Cf121 is 1:4. For example when equal input voltage is impressed to Cp1 to Cp4, INV121 outputs the voltage equal to each input voltage. The capacitance ratio of each capacitance of Cm1 to Cm4, capacitance C12 and Cf122 is 1:4:4. Inputs of Cp1 to Cp4 and of Cm1 to Cm4 are equally weighted. For example when all inputs have the same value of plus or minus, the last output Vout12 is equal to the input. INV121 and INV122 are connected by switches for refreshing SWA121 and SWA122, and controlled by a control signal Ctrl12.

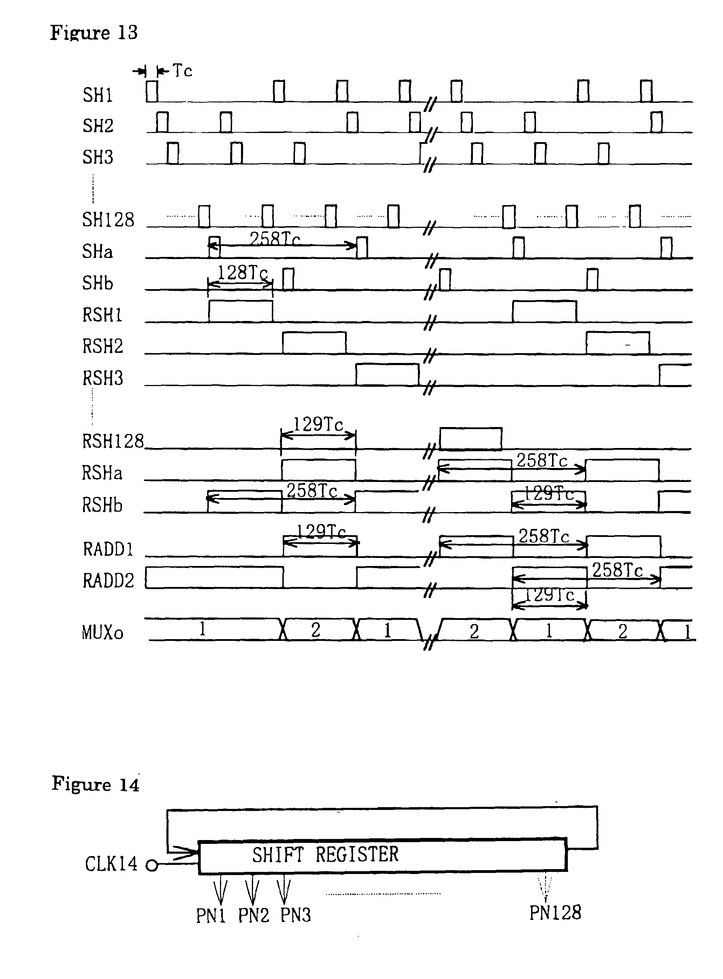

As in Figure 13, the matched filter above intermittently refreshes one of sampling and holding circuits as well as successively performs sampling and holding an analog input in a sampling and holding circuit. In the figure, SH1 to SH128 show the timings of each unit sampling and holding circuit of SH1 to SH128, and SHa and SHb show the timings of auxiliary sampling and holding circuits. Tc of the period of one sampling and holding is enough time for change capacitances in a sampling and holding circuit (Cin4 and Cf4 in Fig. 4). The sampling and holdings are successively performed by SH1 to SH128 in the first period. The broken line shown before SH128 means the omission of the periods of SH4 to SH127. Sampling and holdings by auxiliary sampling and holding circuit SHa are performed after that. If the sampling and holding were performed in the same timing as the first period, SH1 would perform sampling and holding, however SH1 is stopped. The timings of refreshing of SH1 to SH128 are shown by RSH1 to RSH128. As shown by RSH1, SH1 is refreshed during it stops. In the third period, SH2 stops and the auxiliary sampling and holding circuit SHb is used instead of it, at the same time, SH2 is refreshed. One of SH3 to SH128 successively stops and is refreshed by every period. SHa and SHb are alternatively used instead of the stopped unit sampling and holding circuit. When Tc is deemed as unit time, the holding time of SHa and SHb is Tc, and the period of them is 258Tc. The holding time of RSH1 to RSH128 is 128Tc, and the period of them is 129 × 128Tc.

With respect to auxiliary sampling and holding circuits SHa and SHb, one is refreshed when another is used. In the Figure, the timings of refreshing of SHa and SHb are shown by RSHa and RSHb, respectively. For example, refreshing SHb is started in the second period and it is continued until just before using the SHb in the third period. After that, SHb is refreshed until just before using the SHa, and the SHa is refreshed until just before using SHb. They are alternatively refreshed in such a way. The holding time of RSHa and RSHb is 130Tc, and the period of them is 258Tc.

As shown in Figures 2 and 9, auxiliary sampling and holding circuits SHa and SHb are connected to addition and subtraction circuits ADD1 and ADD2, respectively. Therefore, it is necessary to select an addition and subtraction circuit corresponding to the auxiliary sampling and holding circuit. That is, when SHa is used, ADD1 is selected, and when SHb is used, ADD2 is selected. During the period of one of the addition an subtraction circuits is used, another one is refreshed. In the Figure 13, RADD1 and RADD2 show the timing of refreshing of ADD1 and ADD2, respectively. The holding time and the period of RADD1 and RADD2 is 129Tc and 258Tc, respectively.

The multiplexer MUXo selects an output of selected addition and subtraction circuit, and always outputs the effective data as Aout.

The PN codes for multiplying an analog input voltage are used by every period in rotation. The PN code for each unit sampling and holding circuit is stored in a shift register as shown in Fig. 14. A clock CLK14 is input to the shift register by one period of sampling and holding. The PN codes are shifted on every input. The PN codes reached the end of the shift register is back to the start end. In the figure, the PN code for giving SH1, SH2, SH3, ..., SH128 are shown by PN1, PN2, PN3, ..., PN128.

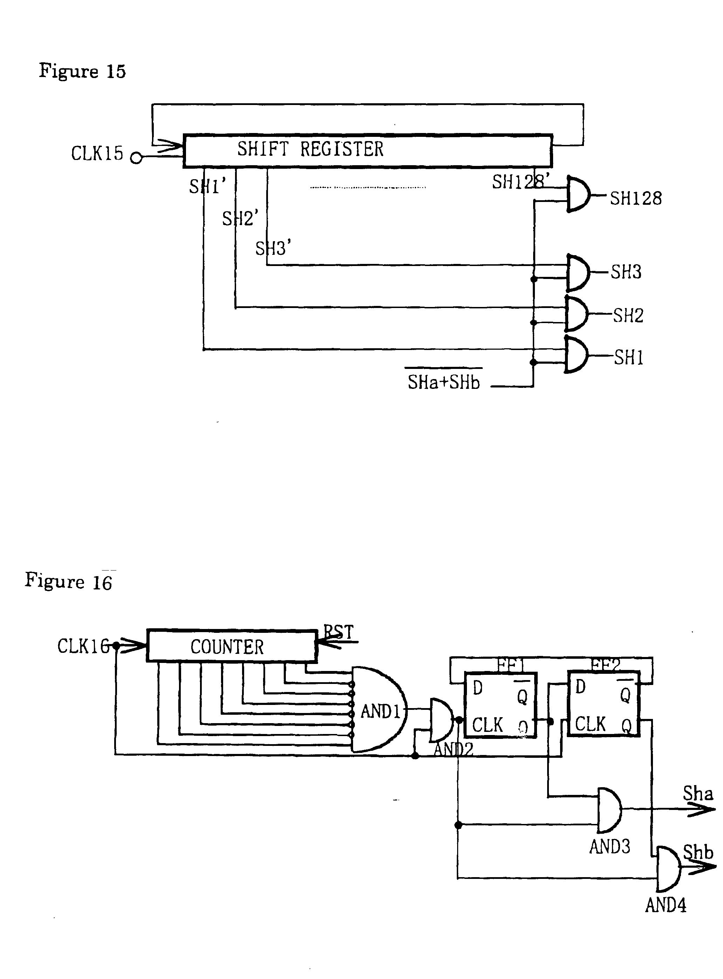

The signal for making each unit sampling and holding circuit performs sampling and holding consists of one signal of 1 and 127 signals of 0. The sampling and holding circuit to which the signal 1 is input performs sampling and holding. The signal is stored in a shift-register in Fig. 15. The sampling and holding is performed by rotating the signal as in Fig. 14. At the timing that the auxiliary sampling and holding circuits are changed, as the sampling and holding have to be stopped, NOR of SHa and SHb and AND of each sampling and holding signal is the final sampling and holding signal. In the Fig. 15, SH1 to SH128 are the final sampling and holding signal, and SH1' to SH128' arc the signals of a predetermined period before AND is executed on auxiliary sampling and holding circuits.

Fig. 16 shows a circuit for generating sampling and holding signals of SHa and SHb. When an output of a 8 bit-counter (shown by COUNTER) is 129 ("10000001" of a binary number), it is judged by AND1 of the first AND circuit, and the AND of the judgment and a clock CLK16 common to the counter is generated by AND2 of the second AND circuit. It is a pulse generated by the cycle of every 129 times of sampling and holding. The pulse is input to a flip-flop FF1, whose output Q is input to the data input of the second stage flip-flop FF2. The inverse output of FF2 is input to a data input of FF1. The sampling and holding circuit SHa is generated by a circuit AND3 to which an output Q of FF1 and an output of AND2 are input. Similar to it, the sampling and holding signal SHb is generated by a circuit AND4 to which an output Q of FF2 and an output of AND2 are input.

As mentioned above, a matched filter according to the present invention, it is additionally settled that
i) a plurality of auxiliary sampling and holding circuits for holding a part of analog input voltage to be held in the main sampling and holding circuit,
ii) the second addition and subtraction circuit including a circuit equivalent to addition and subtraction circuit,
iii) a multiplexer for alternatively outputting an output of addition and subtraction circuit or the second addition and subtraction circuit.
Consequently, a period is settled for stopping a sampling and holding circuit and addition and subtraction circuit in the main sampling and holding circuit; a refresh is performed in the period, therefore, it is possible to obtain higher accuracy of calculation keeping the high speed of calculation by the matched filter according to the present invention.

## Claims

1. A matched filter comprising:
i) a main sampling and holding circuit (SHm) with a plurality of sampling and holding circuits (SH1-SH32) parallelly connected to an input voltage (Ain) for holding said input voltage (Ain) in time series, each said sampling and holding circuit (SHm, SH1-SH32) having first and second outputs (p1, p2, m1, m2) corresponding to first and second values of PN code;
ii) a first adder for adding said first outputs of said sampling and holding circuits (SH1-SH32);
iii) a second adder for adding said second outputs of said sampling and holding circuits (SH1-SH32);
iv) a first addition and subtraction circuit (ADD1) for subtracting an output (tm1) of said second adder from an output (tp1) of said first adder, said first addition and subtraction circuit (ADD1) consisting of addition and subtraction portions (ADD33-1, ADD32-1 to 32-6, ADD33-2, SUB9);
v) a plurality of auxiliary sampling and holding circuits (SHa, SHb) for sampling and holding a part of said input voltage (Ain) to be sampled and held by said sampling and holding circuit (SH1-SH32) in said main sampling and holding circuit (SHm);
vi) a second addition and subtraction circuit (ADD2) consisting of circuits equivalent to those of said first addition and subtraction circuit (ADD1);
vii) a multiplexer (MUXo) for alternatively outputting an output (Aout) of either said first (ADD1) or second (ADD2) addition and subtraction circuit; and
viii) a refreshing means (SWH42, SWA4, SWA10) for refreshing said sampling and holding circuit (SH1-SH32) in said main sampling and holding circuit (SHm), for which said auxiliary sampling and holding circuits (SHa, SHb) hold said input voltage (Ain), and for refreshing said first (ADD1) or second (ADD2) addition and subtraction circuit not selected by said multiplexer (MUXo);
wherein outputs of said sampling and holding circuit (SH1-SH32) and said auxiliary sampling and holding circuit (SHa, SHb) are input in both of said first (ADD1) and second (ADD2) addition and subtraction circuits.

2. The matched filter of claim 1, wherein said auxiliary sampling and holding circuit (SHa, SHb) comprises two of sampling and holding circuits (SHa, SHb) each of which samples and holds said input voltage (Ain), and one of said sampling and holding circuits (SHa, SHb) is refreshed while another of them holds said input voltage (Ain).

3. The matched filter of claim 1 or 2, wherein said refreshing means (SWH42, SWA4) successively refreshes one of sampling and holding circuits (SH1-SH32) in said main sampling and holding circuit (SHm).

## Patentansprüche

1. Signalangepasstes Filter, das aufweist:
I) eine Hauptsignalabtast- und -halteschaltung (SHm), in der eine Vielzahl von Signalabtast- und -halteschaltungen (SH1-SH32) parallel an eine Eingangsspannung (Ain) angeschlossen sind, um diese Eingangsspannung (Ain) in Zeitserien zu halten, wobei jede der Signalabtast- und -halteschaltungen (SHm, SH1-SH32) erste und zweite Ausgangsgrößen (p1, p2, m1, m2) aufweist, die ersten und zweiten Werten eines PN-Code entsprechen;
II) eine erste Additionsschaltung zur Addition der ersten Ausgangsgrößen der Signalabtast- und -halteschaltungen (SH1-SH32),
III) eine zweite Additionsschaltung zur Addition der zweiten Ausgangsgrößen der Signalabtast- und -halteschaltungen (SH1-SH32),
IV) eine erste Additions- und Subtraktionsschaltung (ADD1) zur Subtraktion einer Ausgangsgröße (tm1) der zweiten Additionsschaltung von einer Ausgangsgröße (tp1) der ersten Additionsschaltung, wobei die erste Additions- und Subtraktionsschaltung (ADD1) aus Additions- und Subtraktionsabschnitten (ADD33-1, ADD32-1-32-6, ADD33-2, SUB9) besteht;
V) eine Vielzahl von Hilfssignalabtast- und -halteschaltungen (SHa, SHb) zum Signalabtasten und Halten eines Teils der genannten Eingangsspannung (Ain), die von der Signalabtast- und -halteschaltung (SH1-SH32) in der Hauptsignalabtast- und -halteschaltung (SHm) abgetastet und gehalten werden soll;
VI) eine zweite Additions- und Subtraktionsschaltung (ADD2), die aus Schaltungen besteht, die denen der ersten Additions- und Subtraktionsschaltung (ADD1) gleichen;
VII) einen Multiplexer (MUXo) zur abwechselnden Ausgabe einer Ausgangsgröße (Aout) entweder von der ersten (ADD1) oder der zweiten (ADD2) Additions- und Subtraktionsschaltung; und
VIII) eine Auffrischungseinrichtung (SWH42, SWA4, SWA10) zum Auffrischen der Signalabtast- und -halteschaltung (SH1-SH32) in der Hauptsignalabtast- und -halteschaltung (SHm), für die die Hilfssignalabtast- und -halteschaltungen (SHa, SHb) die Eingangsspannung (Ain) halten, und zum Auffrischen der ersten (ADD1) oder der zweiten (ADD2) Additions- und Subtraktionsschaltung, die jeweils von dem Multiplexer (MUXo) nicht ausgewählt ist;
wobei die Ausgangsgrößen der Signalabtast- und -halteschaltung (SH1-SH32) und der Hilfssignalabtast- und -halteschaltung (SHa, SHb) sowohl in die erste (ADD1) als auch in die zweite (ADD2) Additions- und Subtraktionsschaltung eingegeben werden.

2. Signalangepasstes Filter nach Anspruch 1, wobei die Hilfssignalabtast und -halteschaltung (SHa, SHb) zwei Signalabtast- und -halteschaltungen (SHa, SHb) aufweist, die jeweils die Eingangsspannung (Ain) abtasten und halten, wobei eine der Signalabtast- und -halteschaltungen (SHa, SHb) aufgefrischt wird, während die andere die Eingangsspannung (Ain) hält.

3. Signalangepasstes Filter nach Anspruch 1 oder 2, wobei die Auffrischungseinrichtung (SWH42, SWA4) nacheinander jeweils eine der Signalabtast- und -halteschaltungen (SH1-SH32) in der Hauptsignalabtast- und -halteschaltung (SHm) auffrischt.

## Revendications

1. Filtre adapté, comportant :
i) un circuit principal d'échantillonnage et maintien (SHm) ayant une pluralité de circuits d'échantillonnage et maintien (SH1-SH32) connectés en parallèle à une tension d'entrée (Ain) pour maintenir ladite tension d'entrée (Ain) en série temporelle, chacun desdits circuits d'échantillonnage et maintien (SHm, SH1-SH32) ayant des première et seconde sorties (p1, p2, m1, m2) correspondant à des première et seconde valeurs d'un code de pseudo-bruit (PN),
ii) un premier additionneur pour additionner lesdites premières sorties desdits circuits d'échantillonnage et maintien (SH1-SH32),
iii) un second additionneur pour additionner lesdites secondes sorties desdits circuits d'échantillonnage et maintien (SH1-SH32),
iv) un premier circuit d'addition et de soustraction (ADD1) pour soustraire une sortie (tm1) dudit second additionneur depuis une sortie (tp1) dudit premier additionneur, ledit premier circuit d'addition et de soustraction (ADD1) étant constitué de parties d'addition et de soustraction (ADD33-1, ADD32-1 à 32-6, ADD33-2, SUB9),
v) une pluralité de circuits auxiliaires d'échantillonnage et maintien (SHa, SHb) pour échantillonner et maintenir une partie de ladite tension d'entrée (Ain) à échantillonner et maintenir par ledit circuit d'échantillonnage et maintien (SH1-SH32) dudit circuit principal d'échantillonnage et maintien (SHm),
vi) un second circuit d'addition et de soustraction (ADD2) constitué de circuits équivalents à ceux dudit premier circuit d'addition et de soustraction (ADD1),
vii) un multiplexeur (MUXo) pour émettre en alternance une sortie (Aout) dudit premier circuit d'addition et de soustraction (ADD1) ou dudit second circuit d'addition et de soustraction (ADD2), et
viii) des moyens de rafraîchissement (SWH42, SWA4, SWA10) pour rafraîchir ledit circuit d'échantillonnage et maintien (SH1-SH32) dudit circuit principal d'échantillonnage et maintien (SHm), pour lequel lesdits circuits auxiliaires d'échantillonnage et maintien (SHa, SHb) maintiennent ladite tension d'entrée (Ain), et pour rafraîchir ledit premier circuit d'addition et de soustraction (ADD1) ou ledit second circuit d'addition et de soustraction (ADD2) non-sélectionné par ledit multiplexeur (MUXo),
dans lequel des sorties dudit circuit d'échantillonnage et maintien (SH1-SH32) et dudit circuit auxiliaire d'échantillonnage et maintien (SHa, SHb) sont entrées à la fois dans ledit premier circuit d'addition et de soustraction (ADD1) et ledit second circuit d'addition et de soustraction (ADD2).

2. Filtre adapté selon la revendication 1, dans lequel ledit circuit auxiliaire d'échantillonnage et maintien (SHa, SHb) comporte deux circuits d'échantillonnage et maintien (SHa, SHb), chacun échantillonnant et maintenant ladite tension d'entrée (Ain), et l'un desdits circuits d'échantillonnage et maintien (SHa, SHb) est rafraîchi alors que l'autre maintient ladite tension d'entrée (Ain).

3. Filtre adapté selon la revendication 1 ou 2, dans lequel lesdits moyens de rafraichissement (SWH42, SWA4) rafraîchissent successivement un des circuits d'échantillonnage et maintien (SH1-SH32) dudit circuit principal d'échantillonnage et maintien (SHm).
